# EUROPEAN PATENT SPECIFICATION

(11) **EP 4 056 739 B1**
(45) Date of publication and mention of the grant of the patent: **27.12.2023**
(21) Application number: 21162115.6
(22) Date of filing: 11.03.2021
(51) Int. Cl.: C30B 23/00, C30B 23/02, C30B 29/36

(54) **METHOD OF GROWING HIGH-QUALITY SINGLE CRYSTAL SILICON CARBIDE**
VERFAHREN ZUR ZÜCHTUNG VON HOCHWERTIGEM EINKRISTALLINEM SILIZIUMCARBID
PROCÉDÉ DE CROISSANCE DE CARBURE DE SILICIUM MONOCRISTALLIN DE HAUTE QUALITÉ

(43) Date of publication of application: 14.09.2022
(73) Proprietor: Kiselkarbid i Stockholm AB, 164 40 Kista (SE)
(72) Inventor: DONG, Lin, 163 76 Spanga (SE); EKMAN, Johan, 133 43 Saltsjöbaden (SE)
(74) Representative: Bergenstråhle & Partners AB

(56) References cited:
- EP-A1- 3 382 067
- JP-B2- 5 464 544
- US-A1- 2009 126 624
- US-A1- 2016 118 257
- US-A1- 2018 290 893
- TANAKA HIDEHIKO: "Silicon carbide powder and sintered materials", CERAMIC SOCIETY OF JAPAN. JOURNAL, vol. 119, no. 1387, 1 January 2011 (2011-01-01), pages 218-233, XP055832761, Tokyo, JP ISSN: 1882-0743, DOI: 10.2109/jcersj2.119.218

## Description

### Technical field

The present invention relates generally to a method of growing an epitaxial layer on a substrate of monocrystalline **Si**licon **C**arbide, SiC. Specifically, it relates to a method of growing high-quality silicon carbide single crystals that are nearly free from carbon inclusion and basal plane dislocations.

### Background art

In recent years, there has been an increasing demand for improved electronic devices that are energy efficient and capable of operating at high power levels and high temperatures. **Si**licon, Si, is currently the most commonly used material in semiconductors industry for power devices in high temperature, high voltage and high-power applications. SiC is a highly suitable alternative material because of its high thermal conductivity, high saturated electron drift velocity and high breakdown electric field strength compared to Si.

The most common technique used for growing monocrystalline SiC layers by sublimation is by **P**hysical **V**apor **T**ransport, PVT. With this technique, a seed crystal, on which the monocrystalline layer will grow, and a source material, often in the form of a powder, are both placed in a reaction crucible which is heated to the sublimation temperature of the source material. There is a thermal gradient between the source material and the marginally cooler seed crystal. The thermal gradient encourages vapor phase movement, such that vapor species from the source material are deposited on the seed crystal resulting in growth of the monocrystalline layer.

One such method for producing a monocrystalline SiC where a powder is used as source material is disclosed in EP 3382067 A1. However, using powder as a source material has several disadvantages. The powder often comprises impurities resulting from the manufacturing process. Furthermore, the heat distribution in the powder is not sufficiently homogenous, resulting in less control over the sublimation of the powder and depletion of silicon. An additional disadvantage is the risk of solid particles from the powder falling onto the seed, leading to inclusions and impurities of the final crystalline structure. Furthermore, the stability of SiC powder is another technical challenge for PVT growth. In order to grow relatively thick and large diameter SiC single crystal boules, a correspondingly large amount of SiC powder should be loaded into the crucible. During the PVT growth, the temperatures at the different positions of the SiC powder may be quite different and may lead to recrystallization and even carbonization of the SiC powder. Such problems will significantly deteriorate the crystal quality and the yield of manufacturing single crystal SiC.

A version of PVT is the **S**ublimation **S**andwich **M**ethod, SSM, where, instead of a powder, a monolithic SiC plate is used as a source material. Using a plate is for example beneficial for controlling the temperature uniformity of the source material. Another advantage of this method is the short distance between the source material and the seed crystal/substrate which has the positive effect that vapor species do not react with the walls of the crucible.

US patent no. 7,918,937 discloses a method of producing an epitaxial layer on a substrate of SiC. The source material is a high-purity material which is polycrystalline. The use of polycrystalline source material gives more uniform feeding to the growing epitaxial layer, and thus more uniform properties of layer thickness and doping compared to a monocrystalline material.

The method disclosed in US patent no. 7,918,937 is an improvement over the previously described methods but there is still room for improvements. With increasing interest of the commercialization of SiC power electronic devices in recent years, high quality SiC single crystal wafers with large diameter, mainly referring to 6 inch or more herein, are highly desired. In the conventional PVT method, SiC single crystal is grown in a semi-closed carbon crucible at high temperature. With increasing growth time, Si vapor species sublimated from the SiC powder gradually reduce, making the growth atmosphere more and more carbon rich. At carbon rich conditions, carbon particles can be generated on the sublimated source surface and transferred to the growth surface, named as carbon inclusion defects. The carbon inclusion defects can further trigger the formation of micropipes, carrot defects, stacking faults and other types of defects. Therefore, it is very crucial to obtain a stable and suitable growth atmosphere during the PVT growth. However, this poses a great challenge on the PVT method, since the above-mentioned growth atmosphere becomes more and more complex as the SiC diameter is increasing.

Another problem for bipolar devices produced on SiC substrates and grown by the PVT process is degradation of bipolar devices, especially for devices used in high power applications. The most frequent root cause of such degradation is **B**asal **P**lane **D**islocations, BPDs. Stacking faults in the epitaxial layer originate to a large extent from BPDs propagating from the substrate. Under high current stress, these stacking faults expand and cause an increase in forward voltage of bipolar SiC devices, and an increase of the reverse leakage current and decrease in forward current for nominal unipolar SiC devices, having bipolar contribution from embedded pn-junctions. Currently many device makers accept BPDs in the substrate assuming that they may be converted to **T**hreading **E**dge **D**islocations TEDs during epitaxial buffer layer growth. However, findings by Kazuya Konishi et al. in the article "Stacking fault expansion from basal plane dislocations converted into threading edge dislocations in 4H-SiC epilayers under high current stress", Journal of Applied Physics 114, 014504 (2013), show that BPDs can continue to expand into stacking faults even after conversion into TEDs. Therefore, to avoid bipolar degradation BPD-free substrates are highly desired. Especially in safety critical applications as for example in cars and airplanes. By using the method according to the present invention, the BPD density can be reduced to <5 cm⁻² compared to around 500 cm⁻² typically obtained in 4-inch size PVT grown, high-quality substrates. By reducing the BPD density, stacking fault expansion can largely be avoided and reliable high power SiC devices can be produced.

Thus, as the demand for BPD free SiC monocrystals increases, so does the need to increase production capacity, efficiency and quality, especially for high power applications.

### Summary of invention

An object of the present invention is to achieve a method with which it is possible to grow an epitaxial layer on a substrate of monocrystalline SiC which is essentially nearly free from carbon inclusion and basal plane dislocation. This is accomplished with a method of growing an epitaxial layer on a substrate of monocrystalline SiC comprising, providing a source material of monolithic polycrystalline SiC, with a columnar micro-grain structure and a substrate of monocrystalline SiC, in a chamber of an inner container of a crucible with a distance therein between, arranging a carbon getter in said chamber of the crucible to achieve a stable and suitable Si/C stoichiometry in the inner container, said carbon getter having a melting point higher than 2200° C and having an ability of forming a carbide layer with carbon species evaporated from SiC, reducing pressure in the chamber, inserting an inert gas into the chamber and after insertion keeping the pressure higher than 0,01 mbar, raising the temperature in the chamber to a growth temperature, such that a growth rate between 1 µm/h and 1 mm/h, is achieved, and keeping the growth temperature until a growth of at least 5 µm has been accomplished on the substrate.

In an exemplary embodiment of the method the temperature is raised with an increase of 10° C/min to 50° C/min, preferably about 20°C/min to 30° C/min.

In another exemplary embodiment of the method the temperature is raised to between 1550° C and 2300° C, preferably to about 1950° C.

In yet another exemplary embodiment of the method the pressure during the raising phase is between 150 mbar to 950 mbar and the pressure during the keeping phase is reduced to approximately 0.1 mbar to 10 mbar, preferably to approximately 1 mbar to 3 mbar.

In another exemplary embodiment of the method the pressure in the keeping phase is reduced after the growth temperature has been reached at a pumping rate of 1 mbar/min to 100 mbar/min, preferably at a pumping rate of 5 mbar/min, until a pressure of 0.1 mbar to 10 mbar, preferably 1 mbar to 3 mbar is reached.

In an alternative embodiment of the method the pressure during the raising phase and the keeping phase is approximately 0,01 mbar to 25 mbar, preferably 0.1 mbar to 10 mbar and most preferably 1 mbar to 3 mbar.

In an exemplary embodiment of the method the source material has a micro grain size less than 250 µm, preferably less than 100 µm and most preferably in the range of 1 µm to 50 µm.

In yet another exemplary embodiment of the method the micro grain of the source material has a cubic structure substantially oriented in the [111] or [110] crystal plane.

In another exemplary embodiment of the method the carbon getter is chosen in the group consisting of: Tantalum, niobium and tungsten and preferably has the shape of a foil.

In an alternative embodiment of the method the carbon getter is chosen in the group consisting of: Tantalum, niobium and tungsten and preferably comprises several pieces distributed throughout the inner container.

In another exemplary embodiment of the method a surface of the substrate has a root-mean-square roughness lower than 5 nm, preferably lower than 0.4 nm.

In yet another exemplary embodiment the method further comprises providing a spacer between the source material and the substrate in order to keep the distance between the substrate and the source material fixed at a distance in the range of 0,5 mm-2,5 mm, preferably in the range of 0,7 mm-1,2 mm.

One advantage with this method according to the present invention is that by providing monolithic polycrystalline SiC with columnar micro-grain structure as a source material it is possible to obtain a highly uniform and stable sublimation from the source material and grow a high-quality single crystal SiC nearly free of carbon inclusion defects.

### Brief description of drawings

The invention is now described, by way of example, with reference to the accompanying drawings, in which:
FIG. 1a shows a schematic view of a cross section of a type of source material provided in prior art.
FIG. 1b is an appearance picture of polycrystalline SiC showing the macro-grain structure of the prior art source material.
FIG. 2a shows a schematic view of a cross section of monolithic polycrystalline SiC with a columnar micro-grain structure as source material.
FIG. 2b is an appearance picture of polycrystalline SiC with columnar micro-grain structure.
FIG. 3 is a schematic illustration of a system used for performing the method according to the present invention.
FIG. 4 is a schematic illustration of a preferred arrangement of components inside an inner container of the system in Fig. 3.
FIG. 5 schematically illustrates the temperature variation at the substrate during epitaxial sublimation.
FIGS. 6a and 6b show optical microscope images of samples grown by providing a source material according to the present invention and a type of source material provided in prior art.
FIG. 7 shows a flow chart of the method according to the present invention.
FIG. 8 shows a BPD density map by region (Si-Face) of a 4-inch substrate produced according to the method of the present invention.

### Description of embodiments

In the following, a detailed description of the method of growing an epitaxial layer on a substrate of monocrystalline Silicon Carbide, SiC will be described by way of exemplary embodiments. However, it should be understood that these embodiments are only exemplary and that there are many other embodiments that may be practiced within in the scope of the present invention by a person skilled in the art with help of the teachings in the present disclosure. In the drawing figures, like reference numerals designate identical or corresponding elements throughout the several figures. It will be appreciated that these figures are for illustration purposes only and are not in any way restricting the scope of the invention.

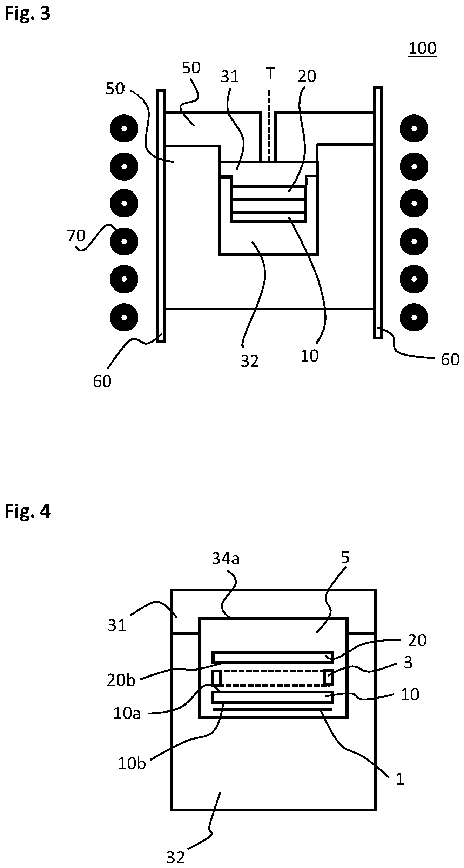

The method of growing the epitaxial layer on the substrate will be performed in a system to facilitate sublimation epitaxy with high growth rate, high reproducibility, and high quality, which will be closer described below in conjunction with Fig. 3 and Fig. 4.

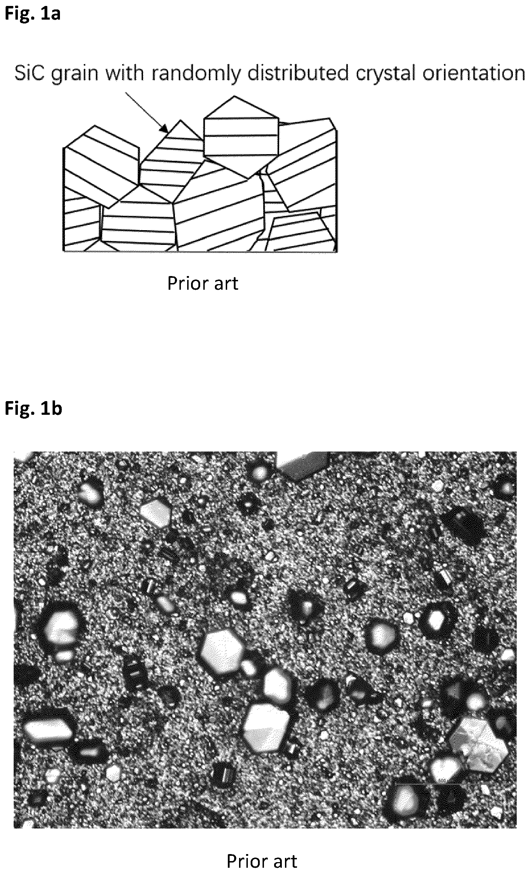

As mentioned above in the background section the most common technique used for growing monocrystalline SiC layers by sublimation is PVT, using a powder as source material. However, as also mentioned above there is a method disclosed in US patent no. 7,918,937 that provides a polycrystalline source material instead of powder. Turning now to FIG. 1a and FIG. 1b the source material provided in US patent no. 7,918,937 will be described more in detail to fully understand the difference of the present invention and method described in US patent no. 7,918,937. **FIG. 1a** shows a schematic view of a cross section of the source material provided in US patent no. 7,918,937. As can be seen the SiC grains have a randomly distributed crystal orientation without any dominating orientation. This source material is also shown, in **FIG. 1b****,** as an appearance picture of polycrystalline SiC showing the macro-grain structure. The grain size for such a source material is larger than 100 µm.

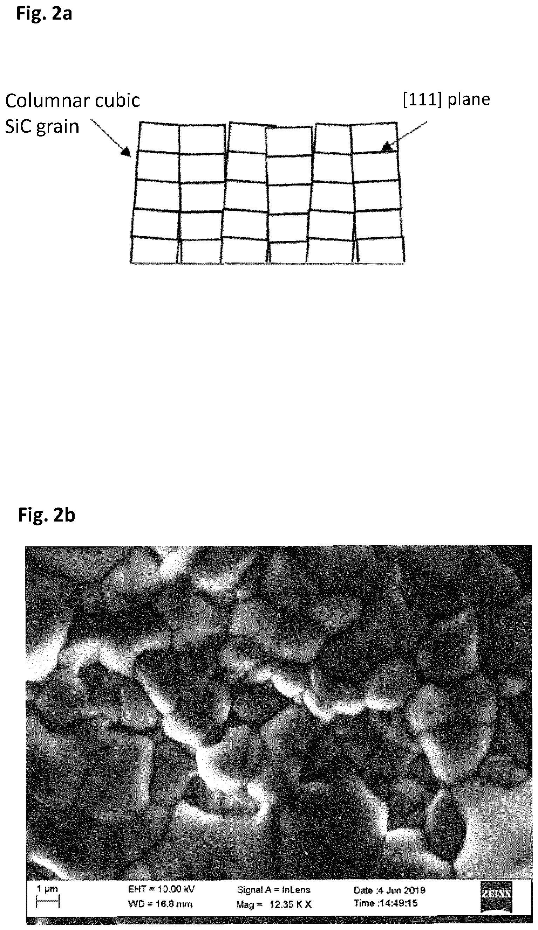

In comparison to the above-described method, the method according to the present invention provides a source material of monolithic polycrystalline SiC with a columnar micro-grain structure as shown in a schematic view of the cross section of the source material in **FIG. 2a****.** The size of the micro-grain in this columnar structure is ranging from 1 µm up to 100 µm and the micro-grain has preferably a cubic structure that is oriented in the [111] crystal plane. In another embodiment the cubic structure may also be oriented in the [110] crystal plane. According to yet another exemplary embodiment the micro grain size may also range from 1 µm up to 250 µm. **FIG. 2b** shows an appearance picture of polycrystalline SiC with columnar micro-grain structure. It is providing a source material with this columnar structure that makes it possible to grow essentially carbon inclusion and basal plane dislocation free substrates. By providing a SiC source material with columnar micro-grain structure a highly uniform and stable sublimation from the source material can be realized, which achieves a high-quality single crystal SiC free of carbon inclusion defects.

**FIG. 3** shows a schematic illustration of a system 100 used for performing the method according to the present invention. In short, the system 100 comprises a crucible, comprising different parts to be described below and heating means 70 surrounding the crucible. When referring to top or bottom parts in the present disclosure, the reference relates to the crucible when in operating condition standing on a floor, platform, or the like. The system 100 is designed to facilitate sublimation epitaxy providing the above mentioned monolithic polycrystalline SiC as the source material 10, which enables the growth of a single crystal SiC layer. The source material 10 and the substrate 20 are arranged in a chamber 5, see FIG. 4, of an inner container, which comprises a top part 31 and a bottom part 32. The inner container 31, 32 is arranged within an insulating container 50, also comprising a top part and bottom part. The insulating container 50 in turn is arranged in an outer container 60. Outside said outer container 60 the heating means 70 is provided, which can be used to heat the cavity of said inner container 31, 32. According to this embodiment the heating means 70 comprises an induction coil for radiofrequency heating. Said outer container 60 is in this example a quartz tube, and said insulating container 50, and said inner container 31, 32 are cylindrical around axis T, and made of an insulating graphite foam and high-density graphite, respectively. The insulating container 50 and the inner container 31, 32 may also be made of another suitable material which has the ability to withstand high temperatures and, if a radiofrequency induction coil is used as the heating means 8, also facilitates coupling to said radiofrequency induction coil. The heating means 70 is used to heat the crucible in order to sublime the source material 10. The heating means 70 is movable in a vertical direction in order to adjust the temperature and thermal drop in the inner container 31, 32. The temperature drop between the source material 10 and substrate 20 can also be altered by varying the properties of the inner container 31, 32, such as the thicknesses of the top part 31 and the bottom part 32 as is known in the art. Additionally, there are pumps (not shown) for evacuating the inner container, i.e., to provide a pressure between about 10⁻⁴ and 10⁻⁶ mbar.

Turning now to **FIG. 4****,** showing a schematic illustration of an exemplary arrangement of different components within the inner container 31, 32 of the crucible, which will be described. The components are a carbon getter 1, a spacer 3, the source material 10 and the substrate 20. The source material 10 and the substrate 20 have a diameter that is adapted to the size of the inner container 31, 32 and depends on what size of substrate 20 that is desired. If the diameter of the inner container 31, 32 is 100 mm, 150 mm, 200 mm, or 250 mm, the inner container 31, 32 is specifically suitable for growth on substrates having a diameter of about 50 mm, 100 mm, 150 mm, or 200 mm, respectively. It is believed to be within the capability of a person skilled in the art to adapt the components and the inner container 31, 32 to a given size of the substrate 20.

The carbon getter 1, in the shown embodiment, is arranged in the inner container 31, 32 close the to the source material 10 and the substrate 20, in this case close to and beneath the source material 10. However, in context of the present disclosure it should be understood that when using the word, a carbon getter it does not necessarily mean that the carbon getter is a single unit but could also be a divided into many small pieces arranged throughout the inner container 31, 32, which will be loser explained in another exemplary embodiment below. The carbon getter 1 is provided to keep a stable and suitable Si/C stoichiometry during growth inside the carbon crucible and facilitates thickness uniformity and also controls the vapor stoichiometry inside the container 31, 32. The properties of the carbon getter 1 are characterized by a high melting point, preferably higher than 2200° C, a high carbon absorbability and a high chemical stability, i.e., the carbon getter 1 has an ability of forming a carbide layer with carbon species evaporated from SiC. The carbon getter 1 is preferably made of tantalum but may also be made of niobium, tungsten, or other materials with such properties. The carbon getter 1 is about 0.05 mm-2 mm, preferably 0,1 mm to 1 mm thick dependable on the how the carbon getter 1 is provided and if it is a single unit or comprises many pieces and may have many different shapes such as a foil, in form of small pieces, a sheet, a plate or have a mesh-like shape. If the carbon getter 1 is in form of small pieces, the small pieces may be shaped slightly curved or L-shaped. The thickness and shape of the carbon getter 1 is chosen carefully such that stable and suitable Si/C stoichiometry is achieved in the inner container 31, 32. When it is made too thin the carbon getter 1 will deform, which may adversely affect the temperature distribution and surface quality of the grown crystal. When the carbon getter 1 is made too thick it might release impurities, such as aluminum compounds comprised therein. A low doped epitaxial layer is reached by use of high-purity graphite material and a suitable carbon getter 1. Some of the properties of the carbon getter 1 are determined when the carbon getter 1 is prepared prior to growth. In another exemplary embodiment the carbon getter 1 comprises may small pieces that are provided at different places in the inner container 31, 32. Some of the pieces are provided underneath the source material to increase the silicon/carbon relation in the inner container and some of the pieces are provided on the sides of the inner container 31, 32 to enhance even growth at the edges of the substrate 20.

The carbon getter 1 acts as a carbon absorber by reacting with C species sublimated from the SiC source during the growth. The arrangement of the carbon getter 1 can, as mentioned above, be made in many different ways as long as it enhances stable and suitable Si/C stoichiometry in the inner container 31, 32. In one exemplary embodiment, as shown in FIG. 4, the carbon getter 1 is placed underneath the source material 10. Such an arrangement can help improving the temperature distribution across the source material 10 horizontally, i.e., in a direction orthogonal to the growth direction of the epitaxial layer. In other words, as the carbon getter 1 couples to the induction RF field generated by the heating means 70 an increased heating of the source material 10 is provided. The carbon getter 1 also facilitates a more even heat distribution across the surface 10b of the source material 10 facing the carbon getter 1. Consequently, the heat is also more evenly spread axially across the substrate 20, i.e., towards the opposite surface 10a of the source material 10, which gives more uniform properties of the epitaxial layer. Even if the exemplary embodiment described above arranges the carbon getter 1 underneath the source material 10, it should be understood and as mentioned above that the carbon getter 1 could be arranged at other locations, such as between or above the source material 10 and the substrate 20, divided into many small pieces distributed along the walls and at the bottom of the inner container 31, 32 as long as it facilitates thickness uniformity and also controls the vapor stoichiometry inside the container 31, 32.

As mentioned above the source material 10 is in the exemplary embodiment arranged above the carbon getter 1 but may also be arranged underneath the carbon getter 1 or surrounded by the carbon getter 1. The thickness of the source material 10 is approximately 0.5 mm-5 mm. Providing a polycrystalline source material 10 with a columnar micro-grain structure gives a more uniform feeding to a growing epitaxial layer 20b of the substrate 20 which leads to more uniform properties of layer thickness and doping.

The substrate 20 is placed on top of the source material 10 but separated therefrom through a spacer 3, having a height in the range of 0,5 mm to 2,5 mm, the height being adapted to the desired distance between the substrate 20 and the source material 10. The spacer 3 is arranged and shaped such that the distance between the substrate 20 and the source material 10 is in the range 0,5 mm-2,5 mm, preferably in the range 0,7 mm and 1,2 mm. The spacer 3 may be ring-shaped or comprise three separate spacers for giving the substrate 20 a stable support. Preferably, the substrate 20 comprises a SiC carbide crystal which has a mirror-like surface and a minimum of surface defects. In an exemplary embodiment the surface of the substrate 20 has a **R**oot-**M**ean-**S**quare (RMS) roughness lower than 5 nm, preferably lower than 0.4 nm. To maintain stable growth of the polytype of SiC crystal inherited from the substrate 20, the off-cut angle of the substrate 20 is in the range of 0 to 8 degrees, preferably 4 degrees. In an exemplary embodiment, the polytype of the grown single crystal is determined by the seed polytype. In order to maintain a good surface morphology and low-density surface defects of the grown SiC crystal, the polarity of the substrate 20, in one exemplary embodiment, is (000-1), also called carbon face. There are also other options, in another exemplary embodiment the polarity of the substrate is (0001), also called silicon face polarity.

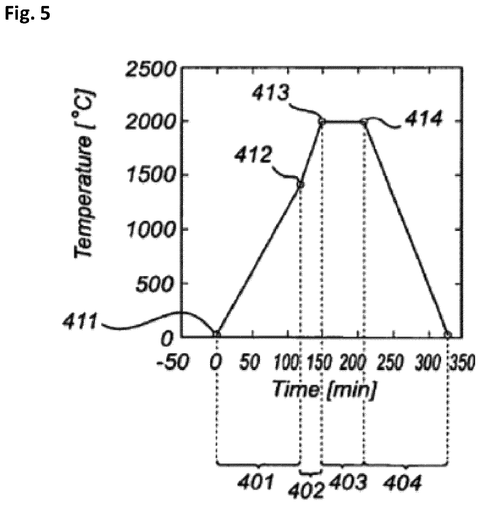

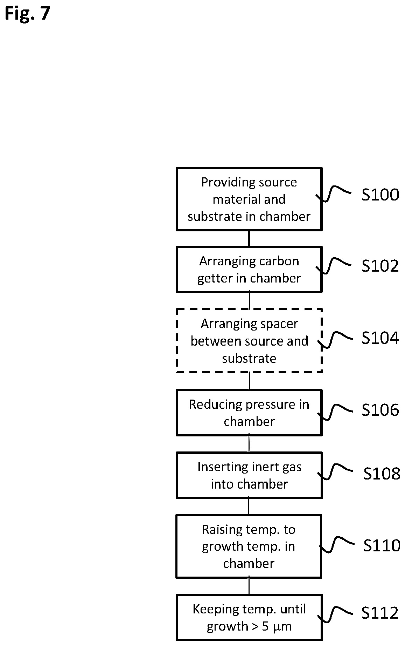

Turning now to FIG. 5 and FIG. 7 the method of growing an epitaxial layer on the substrate 20 of monocrystalline SiC will be described. **FIG. 7** shows the flow chart of the method and **FIG. 5** schematically illustrates exemplary temperature variation at the substrate 20 during epitaxial sublimation. Optional steps of the method are shown with dotted lines. It should be understood that the method according to the present invention is not limited to if the substrate 20 is to be doped or not. The substrate 20 may be doped with for example nitrogen, boron or aluminum. Nitrogen doping is typically induced by nitrogen gas pumped into the chamber 5. P-type substrates may be grown by means of aluminum doping. In such a case aluminum may be introduced into the chamber 5 by means of aluminum carbide powder or gas.

Step S100 of the method provides a source material 10 of monolithic polycrystalline SiC with a columnar micro-grain structure and a substrate 20 of monocrystalline SiC, in a chamber 5 of the inner container 31, 32 of the crucible. The source material 10 and the substrate 20 are arranged with a fixed distance therein between, preferably in the range 0,5 mm-2,5 mm and more preferably in the range 0,7 mm and 1,2 mm. In step S102 a carbon getter 1 is arranged in said chamber 5 of the crucible such that a stable and suitable Si/C stoichiometry is achieved in the inner container 31, 32. The carbon getter 1 has a melting point higher than 2200° C and an ability of forming a carbide layer with carbon species evaporated from SiC, i.e., has a high carbon absorbability and a high chemical stability.

When the source material 10, carbon getter 1 and the substrate 20 all have been provided in the camber 5, the pressure in the chamber 5 is reduced, in step S106. In an exemplary embodiment the pressure during the reducing phase, S106, is reduced to a base vacuum level that is lower than 10⁻³ mbar. The chamber 5 is evacuated using conventional pumping means.

In step S108 an inert gas is inserted into the chamber 5. Any inert gas may be used, but argon is preferred. The pressure is thereafter kept at a pressure higher than 0,01 mbar. In one exemplary embodiment the inert gas is introduced into the chamber 5 until the pressure reaches the range of 1 mbar to 10 mbar. In another exemplary embodiment the inert gas is introduced until the pressure has reached the range of 150 mbar to 950 mbar, preferably 700 mbar. In this second exemplary embodiment, the pressure will be reduced after the growth temperature has been reached (see step S110 below). The pressure will then be reduced at a pumping rate of, e.g., 1 mbar/min to 10 mbar/min preferably 5 mbar/min until a pressure in the range of 1 mbar to 10 mbar has been reached.

In step S110 the temperature in the chamber 5 is raised by means of the heating means 70 to a growth temperature as is shown in the temperature diagram in FIG. 5. The growth process comprises a pre-heating phase 401. During the preheating phase, step S110, the temperature may be increased within an interval from 1° C/min to 245° C/min depending on the circumstances and the balancing between productivity and quality. However, the inventors have discovered that an increase of the temperature between 10° C/min to 50° C/min, and preferably about 30° C/min to 20° C/min provides a good initial sublimation of the source material 10 and nucleation. The pressure during the raising phase, step S110, is as mentioned above normally kept above 0,01 mbar and preferably below 950 mbar. As also mentioned above the pressure during the raising phase may for example be constant in a range of 1 mbar to 10 mbar or for example be reduced with 5 mbar/min from an initial pressure in the range of 150 mbar to 950 mbar, preferably 700 mbar, to a pressure in the range of 1 mbar to 10 mbar during the raising phase, step S110. Step S110 lasts until the temperature has been raised to a suitable growth temperature 413, typically about 1550° C to 2300° C, preferably about 1950° C. When a suitable growth temperature 413 has been reached, i.e., a growth temperature which facilitates a desired growth rate, the temperature increase is quickly decreased. The desired growth rate may be in the interval from 1 µm/h to 1mm/h and again depends on the balancing of productivity and quality. Preferably the growth rate is kept between 10 µm/h to 300 µm/h in order to achieve a good balance. In a preferred embodiment the growth temperature is kept at 1950° C, giving a growth rate of approximately 90 µm/h with the above-described setting. The person skilled in the art knows at which temperatures a desired growth rate is obtained. The temperature is kept at this level 413, until an epitaxial layer of desired thickness has been achieved. The period following the heating phase is referred to as the growth phase 403, during this phase the temperature is preferably kept substantially constant and the pressure during the keeping phase, step S112, is approximately in the range of 1 mbar to 10 mbar, preferably in the range of 3 mbar to 6 mbar. The growth phase, step S112, is kept until a desirably thick SiC single crystal layer has been produced, i.e., at point 414 in Fig. 5. The desirable growth thickness on the substrate 20 is at least 5 µm but typically less than 5000µm. In low doped epitaxial drift layers used in high voltage devices a layer thickness of 10 µm/kV is desirable. In such applications the growth thickness on the substrate 20 is thicker, typically in the range from 10 µm to 200 µm, depending on the voltage class. The doping concentration in such layers is typically below 1 × 10¹⁶ cm⁻³. As an example, for N-type substrates with a doping concentration in excess of 1 × 10¹⁸ cm⁻³, a thickness in the range of 1 mm to 7 mm may be grown. The thickness of the grown crystal is determined by the thickness of the source material 10, which can have a thickness up to 7 mm.

After the desirable thick SiC crystal layer has been produced the heating is turned off and the substrate 20 is allowed to cool down, this is referred to as the cooling phase 404. The pre-heating and the cooling phase can be optimized in order to decrease the production time. When the system is cooled down to room temperature the chamber 5 is refilled with argon or any other safety gas to reach atmospheric pressure and the sample is taken out by opening the chamber 5, which is a well know cooling process for a person skilled in the art. After growth and cooling down the sample can be processed by grinding or successively separated to wafers using any wafer separation technology so that the grown single crystal can be separated from the substrate 20.

In yet another exemplary embodiment a spacer 3, is provided, in optional step S104, between the source material 10 and the substrate 20 in order to keep the distance between the substrate 20 and the source material fixed at a distance of in the range of 0,5 mm-2,5 mm, preferably in the range of between 0,7 mm and 1,2 mm. The spacer 3 has, as mentioned above, a height in the range of approximately 0,5 mm to 2,5 mm and is arranged and shaped such that the distance between the substrate 20 and the source material 10 is kept fixed as mentioned above. As also mentioned above the spacer 3 may be ring-shaped or comprise at least three separate spacers for giving the substrate 20 a stable support.

To illustrate the importance of providing polycrystalline SiC with a columnar micro-grain structure as a source material 10 according to the present invention two experiments were conducted under the same conditions but providing different source materials. In the first experiment polycrystalline SiC with a columnar micro-grain structure according to the present invention, as shown in FIGS. 2a and 2b, was provided as source material. In the second experiment a prior art source material of polycrystalline SiC grains having a randomly distributed crystal orientation without any significant orientation and shown in FIGS. 1a and 1b was provided.

The experiments were performed in a system with face-down configuration, i.e. the growth on the substrate 20 was on the side 20b (Fig. 4) facing downwards towards the source material 10. However, the method according to the present invention is not limited to a system with face-down configuration, but could be performed with a system having a face-up configuration or any other configuration. The experiments were conducted with the following conditions. Once the source material 10, the substrate 20, the spacer 3 and the carbons absorber 1 was loaded into the chamber 5 as described above, the chamber 5 was pumped down to a pressure below 10⁻³ mbar. Thereafter, argon was introduced into the chamber 5 until a pressure of 1 mbar was reached. Then the heating means 70 were turned on and the system was heated up to a desired temperature of 1950° C with a ramp-up rate of around 20° C/min. At the growth temperature of 1950° C, the growth rate was about 90 µm/h and this temperature was kept for four and a half hours until the thicknesses of the grown single crystal SiC was around 500 µm. Thereafter the power to the heating means 70 was cut off and the temperature was decreasing naturally until the system was cooled to room temperature. The chamber was then refilled with argon until atmospheric pressure was reached. The sample was then taken out by opening the chamber 5.

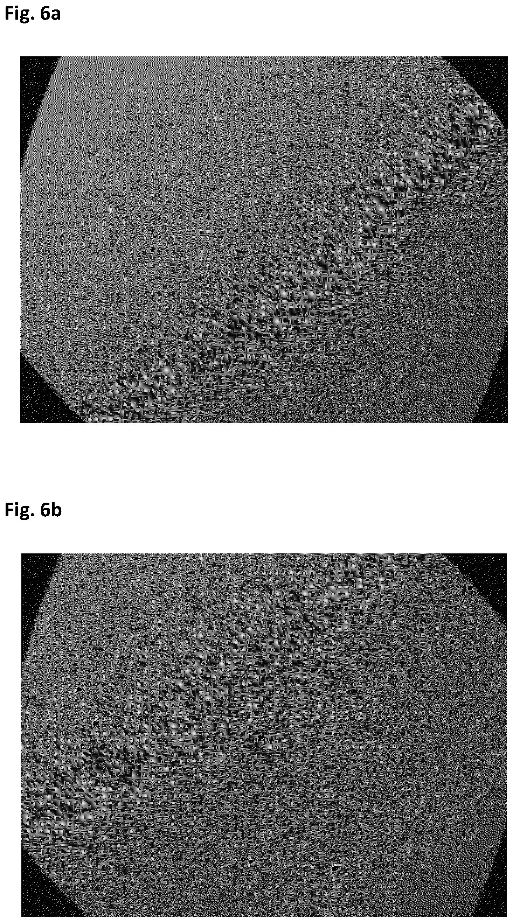

The results of the experiments are shown in **FIG. 6a** and **FIG. 6b.** FIGS. 6a and 6b are optical microscope images of the samples grown by providing the different source materials. FIG. 6a shows the result providing the source material according to the present invention and the FIG. 6b shows the result providing a prior art source material. The thicknesses of grown single crystal SiC for both samples are similar, around 500 µm. After growth, the sample using the source material 10 according to the present invention has very smooth surfaces without any carbon-inclusion, whereas the sample using the prior art source material exhibits a high density of carbon inclusion defects with a density of more than 100 /cm². The carbon inclusion defect is very harmful for the grown crystal quality, since it can trigger new structural defects, like St**a**cking **F**aults, SFs, and BPDs.

Stacking faults and BPDs lead to bipolar degradation of SiC devices applied in high power classes above 1,7 kV. BPDs or BPDs constricted to TEDs, during the initial epitaxial growth and reconverted to BPDs during device operation, cause formation of stacking faults at high current stress, which sooner or later cause the devices to fail. SFs in the epitaxial layer originate to a large extent from BPDs propagating from the substrate. Under high current stress, these SFs expand and cause an increase in forward voltage of bipolar SiC devices, and an increase of the reverse leakage current and decrease in forward current for nominal unipolar SiC devices, having bipolar contribution from embedded pn-junctions.

Eliminating stacking faults formation will contribute to a substantial increase in the reliability of products such as high-power junction barrier Schottky diodes, PiN diodes, insulated gate bipolar transistors and metal oxide semiconductor field effect transistors enabling integration in volume applications during the next decade.

By using the method according to the present invention, the BPD density can be reduced to <5 cm⁻² compared to around 500 cm⁻² typically obtained in 100 mm size PVT grown, high-quality substrates. By reducing the BPD density, SF expansion can largely be avoided, and reliable high power SiC devices can be produced. Examples of such high power SiC devices are inverters and converters for hybrid and all electric cars, inverters for solar and wind power, power factor correctors for high end power applications and devices for power transmission and distribution.

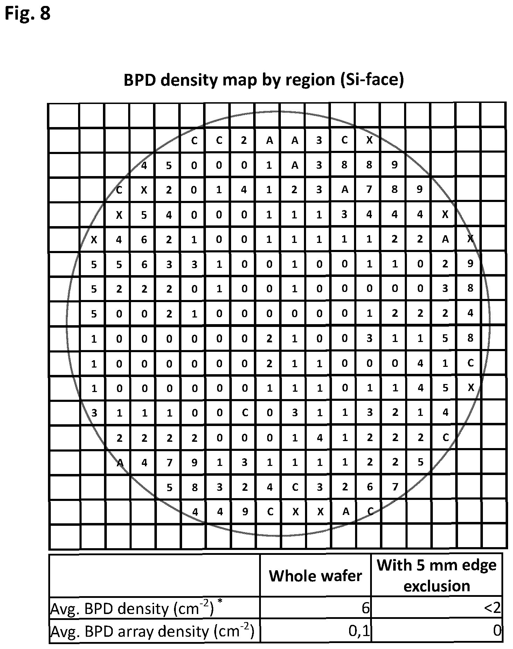

Turning now to **FIG. 8** another example of the quality of a substrate produced according to the method of the present invention is shown. FIG. 8 shows a BPD density map by region (Si-Face) of a 100 mm (4-inch) substrate produced according to the method of the present invention. As can be seen the average BPD density is very low and significantly lower the prior art substrates.

## Claims

1. A method of growing an epitaxial layer on a substrate (20) of monocrystalline **S**ilicon **C**arbide, SiC, comprising:
- providing (S100) a source material (10) of monolithic polycrystalline **S**ilicon **C**arbide, SiC, with a columnar micro-grain structure and a substrate (20) of monocrystalline SiC, in a chamber (5) of an inner container (31, 32) of a crucible with a distance therein between,
- arranging (S102) a carbon getter (1) in said chamber (5) of the crucible to achieve a stable and suitable Si/C stoichiometry in the inner container (31, 32), said carbon getter (1) having a melting point higher than 2200° C and having an ability of forming a carbide layer with carbon species evaporated from SiC,
- reducing (S106) pressure in the chamber (5),
- inserting (S108) an inert gas into the chamber (5) and after insertion keeping the pressure higher than 0,01 mbar,
- raising (S110) the temperature in the chamber (5) to a growth temperature, such that a growth rate between 1 µm/h and 1 mm/h, is achieved, and
- keeping (S112) the growth temperature until a growth of at least 5 µm has been accomplished on the substrate (20).

2. The method according to claim 1, wherein raising the temperature is made with an increase of 100 C/min to 50° C/min.

3. The method according to any one of claims 1 or 2, wherein the temperature is raised to between 1550° C and 2300° C.

4. The method according to any one of claims 1 to 3, wherein the pressure during the raising phase (S110) is between 150 mbar to 950 mbar and the pressure during the keeping phase (S112) is reduced to 0.1 mbar to 10 mbar.

5. The method according to claim 4, wherein the pressure in the keeping phase (S112), is reduced after the growth temperature has been reached at a pumping rate of 1 mbar/min to 10 mbar/min until a pressure of 0.1 mbar to 10 mbar.

6. The method according to any one of claims 1 to 3, wherein the pressure during the raising (S110) phase and the keeping (S112) phase is 0,01 mbar to 25 mbar.

7. The method according to any one of the preceding claims, wherein the source material (10) has a micro grain size less than 250 µm, when measured using a scanning electron microscope.

8. The method according to claim 7, wherein the micro grain of the source material (10) has a cubic structure oriented in the [111] or [110] crystal plane.

9. The method according to any one of the preceding claims, wherein the carbon getter (1) is chosen in the group consisting of: Tantalum, niobium and tungsten and has the shape of a foil.

10. The method according to any one of claims 1 to 8, wherein the carbon getter (1) is chosen in the group consisting of: Tantalum, niobium and tungsten and comprises several pieces distributed throughout the inner container (31, 32).

11. The method according to any one of the preceding claims, wherein a surface of substrate (20) has a root-mean-square roughness lower than 5 nm.

12. The method according to any one of the preceding claims, further comprising providing a spacer (3) between the source material (10) and the substrate (20) in order to keep the distance between the substrate (20) and the source material (10) fixed at a distance in the range of 0,5 mm-2,5 mm.

## Patentansprüche

1. Verfahren zum Züchten einer Epitaxieschicht auf einem Substrat (20) aus monokristallinem Siliziumcarbid, SiC, umfassend:
- Bereitstellen (S100) eines Ausgangsmaterials (10) aus monolithischem polykristallinem Siliziumcarbid, SiC, mit einer säulenförmigen Mikrokornstruktur und einem Substrat (20) aus monokristallinem SiC, in einer Kammer (5) eines Innenbehälters (31, 32) eines Tiegels mit einem Abstand dazwischen,
- Anordnen (S102) eines Kohlenstoff-Getters (1) in der Kammer (5) des Tiegels, um eine stabile und geeignete Si/C-Stöchiometrie im Innenbehälter (31, 32) zu erreichen, wobei der Kohlenstoff-Getter (1) einen Schmelzpunkt von mehr als 2200° C aufweist und eine Fähigkeit aufweist, eine Carbid-Schicht mit einer aus SiC verdampften Kohlenstoffspezies zu bilden,
- Reduzieren (S106) des Drucks in der Kammer (5),
- Einbringen (S108) eines Inertgases in die Kammer (5) und nach dem Einbringen Halten des Drucks höher als 0,01 mbar,
- Erhöhen (S110) der Temperatur in der Kammer (5) auf eine Wachstumstemperatur, sodass eine Wachstumsrate zwischen 1 µm/h und 1 mm/h, erreicht wird, und
- Halten (S112) der Wachstumstemperatur, bis ein Wachstum von mindestens 5 µm auf dem Substrat (20) erreicht wurde.

2. Verfahren nach Anspruch 1, wobei das Erhöhen der Temperatur mit einem Anstieg von 10° C/min bis 50° C/min erfolgt.

3. Verfahren nach einem der Ansprüche 1 oder 2, wobei die Temperatur auf zwischen 1550 °C und 2300 °C erhöht wird.

4. Verfahren nach einem der Ansprüche 1 bis 3, wobei der Druck während der Erhöhungsphase (S110) zwischen 150 mbar und 950 mbar beträgt und der Druck während der Haltephase (S112) auf 0,1 mbar bis 10 mbar reduziert wird.

5. Verfahren nach Anspruch 4, wobei der Druck in der Haltephase (S112) nach Erreichen der Wachstumstemperatur mit einer Pumprate von 1 mbar/min bis 10 mbar/min bis auf einen Druck von 0,1 mbar bis 10 mbar reduziert wird.

6. Verfahren nach einem der Ansprüche 1 bis 3, wobei der Druck während der Erhöhungsphase (S110) und der Haltephase (S112) 0,01 mbar bis 25 mbar beträgt.

7. Verfahren nach einem der vorstehenden Ansprüche, wobei das Ausgangsmaterial (10) eine Mikrokorngröße, unter Verwendung eines Rasterelektronenmikroskops gemessen, von weniger als 250 µm aufweist.

8. Verfahren nach Anspruch 7, wobei das Mikrokorn des Ausgangsmaterials (10) eine kubische Struktur aufweist, die in der [111] oder [110] Kristallebene ausgerichtet ist.

9. Verfahren nach einem der vorstehenden Ansprüche, wobei der Kohlenstoff-Getter (1) aus der Gruppe ausgewählt wird, bestehend aus: Tantal, Niob und Wolfram, und die Form einer Folie aufweist.

10. Verfahren nach einem der Ansprüche 1 bis 8, wobei der Kohlenstoff-Getter (1) aus der Gruppe ausgewählt wird, bestehend aus: Tantal, Niob und Wolfram, und mehrere über den gesamten Innenbehälter (31, 32) verteilte Teile umfasst.

11. Verfahren nach einem der vorstehenden Ansprüche, wobei eine Oberfläche des Substrats (20) einen quadratischen Rauhtiefenmittelwert von weniger als 5 nm aufweist.

12. Verfahren nach einem der vorstehenden Ansprüche, das weiter Bereitstellen eines Abstandshalters (3) zwischen dem Ausgangsmaterial (10) und dem Substrat (20) umfasst, um den Abstand zwischen dem Substrat (20) und dem Ausgangsmaterial (10) auf einem festen Abstand im Bereich von 0,5 mm-2,5 mm zu halten.

## Revendications

1. Procédé de croissance d'une couche épitaxiale sur un substrat (20) de carbure de silicium, SiC, monocristallin, comprenant :
- la fourniture (S100) d'un matériau source (10) de carbure de silicium, SiC, polycristallin monolithique avec une structure colonnaire à micro-grains et un substrat (20) de SiC monocristallin, dans une chambre (5) d'un récipient interne (31, 32) d'un creuset avec une certaine distance entre eux,
- la disposition (S102) d'un getter de carbone (1) dans ladite chambre (5) du creuset pour obtenir une stoechiométrie Si/C stable et appropriée dans le récipient interne (31, 32), ledit getter de carbone (1) présentant un point de fusion supérieur à 2 200 °C et présentant la capacité de former une couche de carbure avec des espèces de carbone évaporées à partir de SiC,
- la réduction (S106) d'une pression dans la chambre (5),
- l'insertion (S108) d'un gaz inerte dans la chambre (5) et, après insertion, le maintien de la pression supérieure à 0,01 mbar,
- l'élévation (S110) de la température dans la chambre (5) à une température de croissance, de telle sorte qu'une vitesse de croissance comprise entre 1 µm/h et 1 mm/h soit atteinte, et
- le maintien (S112) de la température de croissance jusqu'à ce qu'une croissance d'au moins 5 µm ait été réalisée sur le substrat (20).

2. Procédé selon la revendication 1, dans lequel l'élévation de la température est réalisée selon une augmentation de 10 °C/min à 50 °C/min.

3. Procédé selon l'une quelconque des revendications 1 ou 2, dans lequel la température est élevée jusqu'à être comprise entre 1 550 °C et 2 300 °C.

4. Procédé selon l'une quelconque des revendications 1 à 3, dans lequel la pression pendant la phase d'élévation (S110) est comprise entre 150 mbar et 950 mbar et la pression pendant la phase de maintien (S112) est réduite entre 0,1 mbar et 10 mbar.

5. Procédé selon la revendication 4, dans lequel la pression dans la phase de maintien (S112) est réduite une fois que la température de croissance a été atteinte à un débit de pompage de 1 mbar/min à 10 mbar/min jusqu'à une pression de 0,1 mbar à 10 mbar.

6. Procédé selon l'une quelconque des revendications 1 à 3, dans lequel la pression pendant la phase d'élévation (S110) et la phase de maintien (S112) est de 0,01 mbar à 25 mbar.

7. Procédé selon l'une quelconque des revendications précédentes, dans lequel le matériau source (10) présente une taille de micro-grain inférieure à 250 µm, lorsqu'elle est mesurée à l'aide d'un microscope électronique à balayage.

8. Procédé selon la revendication 7, dans lequel le micro-grain du matériau source (10) présente une structure cubique orientée dans le plan cristallin [111] ou [110].

9. Procédé selon l'une quelconque des revendications précédentes, dans lequel le getter de carbone (1) est choisi dans le groupe consistant en : le tantale, le niobium et le tungstène, et présente la forme d'une feuille.

10. Procédé selon l'une quelconque des revendications 1 à 8, dans lequel le getter de carbone (1) est choisi dans le groupe consistant en : le tantale, le niobium et le tungstène, et comprend plusieurs morceaux répartis dans tout le récipient interne (31, 32).

11. Procédé selon l'une quelconque des revendications précédentes, dans lequel une surface du substrat (20) présente une rugosité moyenne quadratique inférieure à 5 nm.

12. Procédé selon l'une quelconque des revendications précédentes, comprenant en outre la fourniture d'un élément d'espacement (3) entre le matériau source (10) et le substrat (20) afin de maintenir la distance entre le substrat (20) et le matériau source (10) fixée à une distance dans la plage de 0,5 mm-2,5 mm.
